# EUROPÄISCHE PATENTSCHRIFT

(11) **EP 1 818 168 B1**
(45) Veröffentlichungstag und Bekanntmachung des Hinweises auf die Patenterteilung: **26.03.2014**
(21) Anmeldenummer: 05745216.1
(22) Anmeldetag: 12.04.2005
(51) Int. Cl.: B32B 5/22, H01B 1/00

(54) **MATERIAL FÜR BAUTEILE VON RADIOELEKTRONISCHEN VORRICHTUNGEN**
MATERIAL FOR COMPONENTS OF RADIO-ELECTRONIC DEVICES
MATERIAU POUR COMPOSANTS D'APPAREILS RADIOELECTRONIQUES

(30) Priorität: 10.11.2004 RU 2004132378
(43) Veröffentlichungstag der Anmeldung: 15.08.2007
(73) Patentinhaber: Tsoy, Bronya, Moscow, 117342 (RU)
(72) Erfinder: TSOY, Bronya, Moscow, 117342 (RU); LAVRENTIEV, Vladimir Vladimirovich, Krasnodarsky krai 353390 (RU)
(74) Vertreter: Lemcke, Brommer & Partner
(86) Internationale Anmeldenummer: PCT/RU2005/000185
(87) Internationale Veröffentlichungsnummer: WO 2006/052158

(56) Entgegenhaltungen:
- GB-A- 2 378 582
- RU-C1- 2 062 001
- RU-C1- 2 136 787
- RU-C2- 2 183 882
- RU-C2- 2 209 788
- SU-A1- 550 699
- SU-A1- 722 429
- SU-A1- 1 308 111
- SU-A1- 1 683 361
- BER A.J. ET AL: 'Vyschaya shkola' SBORKA POLUPROVODNIKOVYKH PRIBOROV I INTEGRALNYKH SKHEM 1981, XP008098549

## Beschreibung

### Technisches Gebiet

Die vorliegende Erfindung bezieht sich auf die technische Physik und kann im Gerätebau zur Herstellung geräuscharmer funkelektronischer Bauteile von grosser und übergrosser Präzision (Widerstände, Kondesatoren, Induktivitätsspulen, Strompfäde od. dgl.) sowie in anderen Bereichen, in welchen eine grosse und übergrosse Präzision bei der Kontrolle und der Messung von elektrischen Werten benötigt wird, Anwendung finden.

### Stand der Technik

Bekannt sind bereits funkelektronische Bauteile (Bauelemente), die unter Anwendung von einschichtigen (Einelement-) Folien- und Fasersoffen hersgestellt sind. Gehen wird nun einer Veranschaulichung halber auf Nachteile der Geräte ein, welche durch mangelhafte physikalische Eigenschaften der elektronischen Elemente bedingt sind.
1. Widerstände, hergestellt aus einem dünnen Einzeldraht (z.B. aus Nichrom oder Wolfram), oder flache aufgedampfte Folienwiderstände od. dgl. [1]. Nachteilig wirken sich bei diesem Widerstand dessen Widerstandswert beim Durchgang eines elektrischen Stromes R in Höhe von 15 bis 20 % bezogen auf den, in den Technischen Bedingungen für dieses elektronische Gerät angegebenen Nennwert und ein hoher Geräuschpegel bei dessen Betrieb aus.
2. Kondensatoren mit einer einschichtigen dielektrischen Folien-Zwischenschicht aus beispielsweise Glimmer, Polystyrol, Fluorkunststoff, Polyimid od. dgl. [1]. Nachteil eines solchen Kondensators sind ein Fehlergrad der Kapazität und der Durchschlagsspannung in Höhe von 10 bis 15 % bezogen auf den, in den Technischen Bedingungen angegebenen Nennwert und ein hoher Geräuschpegel.
3. Induktivitätsspulen mit einschichtigen Draht- oder Folienstrompfäden [2]. Nachteil aller Induktivitätsspulen einschl. der biegsamen Induktivitätsspulen sind in den Technischen Bedingungen angegebene fehlerhafte Werte der Induktivität und der Güte.
4. Elektronische gedruckte Leiterplatten aus einschichtigen Folienstoffen [3]. Nachteil der elektronischen Leiterplatten sind eine Streuung der tgδ-Werte und hohe dielektische Verluste (ein tgδ-Wert liegt zwischen 10⁻² und 10⁻³), so dass die stabile Wirkungsweise des Gerätes eingebüsst wird, die Funksignalleistung sinkt und deren Einsatz bei Höchstfrequenzgeräten nicht mehr möglich ist.
5. Elektrische Kabelmäntel aus einschichtigen Isolierfolienstoffen wie z. B..Polyethylen, PVC, od. dgl [3]. Nachteilig wirken sich bei den Kabeln ebenfalls eine Streuung von Werten des Wellenwiderstandes R und der Durchschlagsspannung U des Elektroisoliermantels des Kabels in Höhe bis 15 % bezogen auf den in den Technischen Bedingungen angegebenen Nennwert und ein hoher Geräuschpegel aus.

Von der Streuung der physikalischenen Werte, wie Widerstand R, Kapazität C, Induktivität L, dielektrischer Verlustfaktor tgδ hängt insgesamt der Fehlergrad der elektrischen Daten von funkelektronischen Bauteilen und Geräten ab. Ein Nachteil aller funkelektronischen Bauteile und Geräte sind daher die Fehler, die sich aus einer Streuung der Werte der Widerstände, der Kapazität, der Induktivität und der dielektrischen Verluste der Werkstoffe für die Leiterplatten od. dgl. [4] ergeben. Ausserdem, wie hoch auch die elektrischen Werte eines elektronischen Bauteiles oder Gerätes sein mögen, soll dieses wenigstens einen minimalen Vorrat an der Lebensdauer und Festigkeit aufweisen. Hinzu kommt auch, dass ein beliebiges elektronisches Gerät umweltfreundlich und zuverlässig sein und keine übermässige Geräusche erzeugen soll. Dabei besitzt ein jedes Gerät einen bestimmten Geräuschpegel, der desto grösser ist, je höher Fehler der Bauteile des elektronischen Gerätes sind.

Aus der GB 2 378 582 A ist eine Funkabschirmung für elektronische Bauteile bekannt, die einen Mehrschichtaufbau aus zwei Isolatorfolien aufweist, zwischen denen eine Abschirmfolie sandwichartig angeordnet ist. Die Isolatorfolie besteht vorzugsweise aus Polyimid, während die Abschirmfolie aus Kupfer bestehen kann.

Um unerwünschten Fehlern eines elektronischen Gerätes zu begegnen, dessen elektrische Werte zu stabilisieren und den eigenen Geräuschpegel zu senken, modifizieren heutzutage die Erforscher die chemische Struktur und entwickeln hochreine fehlerfreie Werkstoffe, indem sie sich der teueren hohen Technologien bedienen, was allerdings einen hohen Energiebedarf und hohe Finanzmittel nach sich zieht.

### Darstellung der Erfindung

Aufgabe der Erfindung ist es, einen Werkstoff bereitzustellen, der durch eine niedrige und eine extra niedrige Streuung der physikalischen Eigenschaften ohne Modifikation der chemischen Struktur bei einem geringen eigenenen Geräuschpegel, einer hohen mechanischen und elektrischen Festigkeit und Lebensdauer gekennzeichnet ist.

Die Erfindung beruht auf der Anwendung der entdeckten [5 bis 8], universellen, allgemeinen naturgemässen Gesetzmässigkeiten der Änderung physikalischer Eigenschaften von Einelement- (B.Zoj-Effekt) und Mehrelementstrukturen, also eines Mehrelement-Massstabseffektes (des Zoj-Kartaschow-Scheweljow-Effektes), und auf der Entdeckung der allgemeinen Gesetzmässigkeiten der Datenstreuung bei physikalischen Messungen.

Gemäss diesen Entdeckungen vollzieht sich bei einer Verminderung der Längenabmessungen von Einelementstrukturen (Folien und Fasern) eine hohe Verstärkung der physikalischen Eigenschaften von Polymeren und Festkörpern, während bei einer Vereinigung dieser Einelementstrukturen zu einem Bündel (Stapel) ein übergrosser Anstieg der physikalischen Eigenschaften und eine zur Anzahl der Elemente im Bündel propotionelle Verringerung der Dispersion feststellbar sind, d. h. dass sich die Datenstreuung in einem Versuch bei einer Zunahme der Anzahl von typengleichen Einzelementen im Bündel ermässigt.

Das technische Ergebnis erreicht man durch die Inanspruchnahme des entdeckten Effektes, bei dem die Streuung der elektrophysikalischen Werte eines Nichtleiters bei einer Vereinigung der Einzelfolien (Einzelfasern) zu einem mehrschichtigen, aus einer Anzahl N von Elementen aus einem einzigen Material bestehenden Stapel abgebaut wird, wobei N > 1 ist. Dabei kann die Konfiguration der dünnen Folien oder Fasern (Fäden, eines Einzeldrahtes) willkürlich ausgewählt werden. Deren Vereinigung zu einem Bündel bzw. Stapel verbessert gleichzeitig die Struktur von Werkstoffen und ihre Festigkeitswerte. Ein weiterer überraschender Effekt, den die Erfinder festgestellt haben, ist, dass sich der eigene Geräuschpegel von aus den genannten Werkstoffen gebauten Geräten ermässigt. Die Zusammenfassung zu einem mehrschichtigen Stapel ermöglicht es, beliebige Werkstoffe zu verbessern, die aus einschichtigen (Einzel-) Werkstoffen bestehen.

Um die eingangs genannten Nachteile zu beheben, werden dünne Fäden (Folien) mit einer Dicke d₀ von < 80 µm zu einem Bündel (Stapel) aus Elementen in einer Menge von N > 1 zusammengefasst. Die Bauelemente des Bündels können aus belibiegen stromleitenden Werstoffen bestehen.

Die dielektrische Zwischenschicht eines Kondensators wird ausgehend von einem Stapel der Folienschichten in einer Menge von N > 1 mit je einer Dicke d₀ von < 80 µm hergestellt. Die Folien können aus einem beliebigen dielektrischen Werkstoff bestehen.

Für einen Induktivitätskreis verwendet man ein Bündel (einen Stapel) von stromleitenden (flachen oder anders ausgestalteten) Elementen in einer Menge von N > 1 mit je einer Dicke d₀ von < 80 µm.

Für elektronische gedruckte Leiterplatten benutzt man einen mehrschichtigen Stapel aus dünnen Einzelfolien mit je einer Dicke d₀ von < 80 µm bei Schichten als Elementen in einer Menge von N > 1. Die Folien können aus beliebigen dielektrischen Werkstoffen bestehen.

Für einen Elektroisolierstoff soll ein Stapel oder ein Bündel aus dünnen Folien (Fasern) mit je einer Dicke d₀ von < 80 µm bei Schichten als Elementen in einer Menge von N > 1 eingesetzt werden. Die Folien können aus einem beliebigen Werkstoff, wie z. B. einem Polymer hergestellt werden.

### Kurze Beschreibung der Zeichnungen

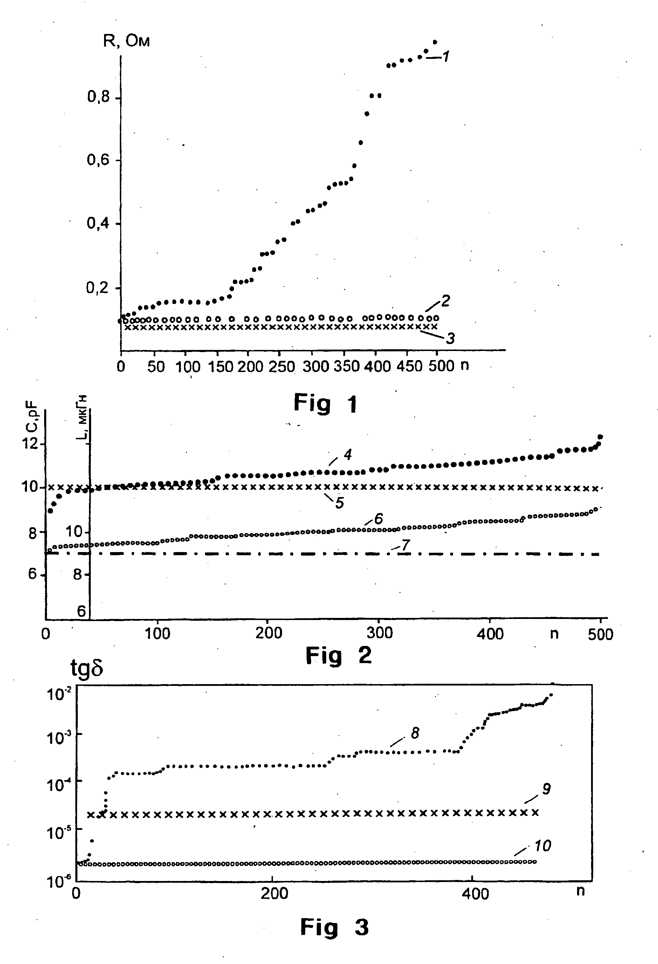

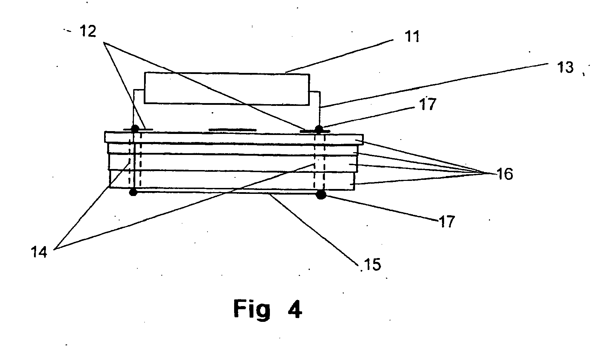

Die Versuchswerte zum Nachweis der Erreichbarkeit eines technischen Ergebnisses der Erfindung zeigen die Figuren 1 bis 3 in Form einer Reihe von Variationsdiagrammen zur Verteilung der Werte R, C, L, tgδ. Dies sind die sogenannten Integralkurven für die Verteilung der Werte R, L, C, tgδ, welche Integralkurven ausgehend von einer Reihe von 500 Versuchsproben gezeichnet worden sind. Die graphischen Messdaten sind als Reihe aufgeführt, bei welcher die Nummern der Folge n ansteigen. Fig. 4 zeigt eine flexible mehrschichtige Leiterplatte, die aus 4 Polyimid-Folien besteht.

### Ausführungsformen der Erfindung

Der Werkstoff für die Bauteile von funkelektronischen Geräten hat eine mehrschichtige Struktur, die durch Schichten dünner Folien in einer Menge von N > 1 gebildet ist, wobei die Schichten aus typengleichen Einzelfolien oder -fasern mit einer Dicke d₀ von < 80 µm aus einem einzigen Material bestehen, die zu einem Stapel oder einem Bündel zusammengefasst sind, wobei sich bei einem Anstig der Zahl der Schichten im Stapel oder der Fasern als Elemente im Bündel bei der angegebenen Dicke die physikalischen Eigenschaften proportionell dazu verstärken und deren Dispersion abnimmt. Als Folien eignet sich Polyimid oder Quarz oder Glimmer oder Kupfer oder Silber oder Germanium oder Gallium. Als Werkstoff für die Fasern als Elemente kommt Silber oder Kupfer oder Alluminium oder Nichrom oder Germanium oder Gallium in Frage.

Eine Polyimidfolie, wie z. B. (PM-1), wird durch ein Giessverfahren unter Anwendung des Polyimidlackes AD-9103, der ausgehend von einer Dimethylformamid-Lösung hergestellt ist, erzeugt.

Die Polyimidfolie ist durchsichtig, ihre Farbe ändert sich je nach der Dicke von dunkelgelb bis hin zu hellbraun.

Die Folie PM-1 zeichnet sich durch hohe physikalisch-mechanische Eigenschaften aus. Sie bleibt in einem breiten Temperaturbereich elastisch, weist eine hohe Ermüdigungsbeständigkeit und Lebensdauer sowie ein niedriges Kriechen auf. Die Polyimidfolie zählt zu Antifriktionsmaterialien. Sie ist in organischen Lösungsmitteln nicht löslich, ölbeständig und wird unter Einwirkung von konzentrierten Säuren und Alkalien zersetzt (hydrolisiert). Sie hat eine hohe Beständigkeit gegen Bestrahlung.

Die grundsätzliche Besonderheit dieses Werkstoffes zeigt sich in dessen Fähigkeit zur Erhaltung der mechanischen und Elektroisoliereigenschaften in einem breiten Temperaturbereich (von -200 bis +400 °C).

Polyimidfolien als Isolierstoff werden weitgehend im Flugwesen, der Elektrotechnik, der Hochfrequenztechnik und in vielen anderen Industriezweigen eingesetzt. Deren Verwendung als Elektroisolation gestattet es, die spezifische Leistung und die Betriebssicherheit von elektrischen Maschinen, Mechanismen und Geräten zu verbessern, deren Betriebstemperatur zu erhöhen und deren Volumen und Gewicht zu verringern. Die Folie lässt sich gut metallisieren.

Grundsätzliche Anwendungsgebiete :
- Produktion von Folienmaterialien und Integrierschaltungen ;
- gedruckte Leiterplatten und Magnetbänder.

**Tabelle 1**

| Hauptsächliche physikalisch-mechanische und elektrische Eigenschaften der Polyimidfolie PM-1 | |
|---|---|
| Eigenschaften | Werte |
| Dielektrischer Verlustfaktor bei 10³ Hz | 0,0025 bis 0,003 |
| Spezifischer Volumenwiderstand, Ohm . m | 10¹⁴ bis 10¹⁵ |
| Wärmeleitzahl, W/m. K | 0,14 bis 0,20 |
| Spezifische Wärmekapazität | 10¹⁴ bis 10¹⁵ |
| Linearer Wärmeausdehnungskoeffizient (20 bis 250)° C | (20 bis 30). 10¹⁵ |

Fig. 1 zeigt Verteilungen der Messdaten für den Widerstand R entsprechend den Nummern der Folge n für drei Serien von je N = 500 der Versuchsproben, die beim Messen von Einzelproben (N = 1) aus einem Kupferdraht mit einer Dicke von 5 µm und einer Länge von *l* = *10 mm* getestet wurden (Kurve 1 in Fig. 1). Wie aus diesen Daten ersichtlich, handelt es sich hier um eine bedeutende Streuung von 0,1 bis 1,0 Ohm. Nach Vereinigung zu einem N > 1 und N >> 1 starken Bündel (Kurven 2 und 3 in Fig. 1) fällt die Streuung überraschend auf Null ab. Hierbei führt der Anstieg der Bauteile N im Stapel (oder dem Bündel) zu einer weiteren Senkung des Widerstandswertes R (Kurve 3 in Fig. 1).

Ähnliche Daten wurden auch für die Werte L, C, tg δ (Figuren 2 und 3) der Einzelfolien oder Einzeldrähte mit einer Dicke von weniger als 80 µm und bei einer Menge der Bauelemente im Stapel (Bündel) von über 1 erhalten.

Fig. 2 zeigt :
4, 5: Verteilung der Kapazität C für eine Polyethylenterephtalat-Folie ; 4 : Einzelfolie mit einer Dicke d von 20 µm (Zahl der Schichten als Elemente : N = 1); 5 : eine mehrschichtige Folie mit einer Schichtenzahl von N > 1, die Schichtdicke beträgt d = 20 µm ;
6, 7 : Verteilung der Induktivität L bei Anwendung eines Kupferdrahtes ; 6: Induktivitätsspule mit einem Einzeldraht bei einer Dicke d von 30 µm, 6 Windungen und einem Wicklungsquerschnitt von 5 mm; 7 : Bündelinduktivitätsspule mit einer Anzahl von Einzeldrähten im Bündel von N > 1 mit einer Dicke d von 30 µm, die Spule hat 6 Windungen, der Wicklungsquerschnitt beträgt 5 mm.

Fig. 3 zeigt :
8 : Verteilung des dielektrischen Verlustfaktors für eine Polyimid-Folie PM-4 mit einer Dicke d von 35 mm, die Längenabmessungen der Probe betragen 10 x 10 mm;
9, 10: Verteilung des dielektrischen Verlustfaktors tgδ für eine mehrschichtige Polyimid-Folie PM-4; die Dicke d der Einzelschicht beträgt 35 mm, die Schichtenzahl N ist von > 1.

Aus diesen Versuchsdaten ergibt sich die Erreichung des technischen Ergebnisses in einem Bündel mit einer Anzahl der Elemente von N > 1, und zwar wird die Streuung der Versuchswerte L, C, tg δ in einem Bündel aus dünnen Einzelbauteilen mit einem Durchmesser d von < 80 µm gleich Null.

Nachweise für die Erreichung des technischen Ergebnisses, wie hohe Festigkeit der mehrschichtigen Strukturen aus dünnen Elementen mit einer Dicke von weniger als 80 µm, sind in Tabellen 2 und 3 zum Ausdruck gebracht. Aus den Tabellen 2 und 3 geht hervor, dass bei Stapeln aus dünnen Folien eine beachtliche Erhöhung der Festigkeit zu verzeichnen ist. Für massige Folien mit einer Dicke von über 80 µm wird der Effekt, bei dem sich die physikalischen Eigenschaften verstärken, nicht beobachtet.

**Tabelle 2**

| Gesamtdicke einer mehrschichtigen Struktur (eines Stapels), D_{N} | Anzahl der in der mehrschichtigen Struktur (dem Stapel) enthaltenen Folien als Elemente, N | Mittelwert der Durchschlagsspannung *E̅̅̅*, kW/ µm |
|---|---|---|
| 1 | 2 | 3 |
| 3 µm | 1 | 1,4 |
| 6 µm | 2 | 1,9 |
| 9 µm | 3 | 2,8 |
| 33 µm | 11 | 4,5 |

| 1 | 2 | 3 |
|---|---|---|
| 10 µm | 1 | 0,91 |
| 20 µm | 2 | 1,15 |
| 30 µm | 3 | 1,23 |
| 60 µm | 6 | 1,4 |
| 80 µm | 8 | 1,6 |
| 20 µm | 1 | 0,5 |
| 40 µm | 2 | 0,6 |
| 80 µm | 1 | 0,26 |
| 160 µm | 2 | 0,26 |

**Tabelle 3**

| Gesamtdicke einer mehrschichtigen Struktur (eines Stapels), D_{N} | Anzahl der in der mehrschichtigen Struktur (dem Stapel) enthaltenen Folien als Elemente, N | Mittelwert der Bruchspannung, MPa |
|---|---|---|
| 145 µm | 1 | 100 |
| 290 µm | 2 | 100 |
| 580 µm | 4 | 100 |
| 1160 µm | 8 | 100 |
| 18 µm | 1 | 430 |
| 36 µm | 2 | 450 |
| 72 µm | 4 | 500 |
| 144 µm | 8 | 700 |

Ein Werkstoff für das Bauteil eines funkelektronischen Gerätes kann beispielsweise in folgender Weise hergestellt werden.

### Beispiel 1

Man wählt eine Folie aus einem stromleitenden Werkstoff, wie z. B. eine Kupferfolie mit einer Dicke d von < 80 µm aus. Diese Folie wird zu einem mehrschichtigen Stapel zusammengefaltet. Die Schichtenzahl richtet sich nach dem gewünschten Widerstandswert R. Zwischen den Folienschichten wird eine Isolierschicht z. B. aus Papier mit einer Dicke von einigen µm eingelegt. Unter einem Stapel im Sinne der vorliegenden Erfindung wird eine mehrschichtige (Mehrelement-) Struktur verstanden, welche eine untere Schicht, eine obere Schicht und Zwischenschichten aufweist, von welchen jede Schicht in beliebiger bekannter Weise auf der nächstliegenden unteren Schicht angeordnet ist. Nachher werden aus solchem Stapel in Form eines Buches Werkstücke erforderlicher Gestalt und Grösse, z. B. rechteckige Werkstücke, ausgestanzt, wobei an den gegenüberliegenden Seiten eines solchen Werkstückes Elektroden angelötet werden. Ein einfachster Widerstand ist nun fertig.

Ein Widerstand kann aber auch durch Aufdampfung hergestellt werden. In diesem Fall werden Isolierschichten ebenfalls unter Anwendung einer Oxidfolie aufgedampft.

Eine irgendwelche zusätzliche Anlage für die Realisierung dieses Beispiels erübrigt sich, denn alles ist im Rahmen der z. Z. bestehenden Technologie durchführbar.

### Beispiel 2

Man wählt eine kommerzielle Folie aus einem Polyimid mit einer Dicke d₀ von < 80 µm aus. Die Folie wird vielfach zusammengefaltet. Danach (wenn eine kleine Leiterplatte z. B. für eine Dünnfolie-Mikroschaltung hergestellt werden soll) werden aus diesem Stapel in Form eines Buches Werkstücke mit den Grössen und der Gestalt der späteren elektronischen Leiterplatte ausgestanzt. Das Werkstück für die Leiterplatte wird auf der Passstelle aufgelegt. Auf das in dieser Weise vorbereitete Werkstück für die elektronische Leiterplatte wird dann die gewünschte elektronische Schaltung aufgedampft.

Für übliche gedruckte Leiterplatten und biegsame gedruckte Kabel werden typengleiche Folien oder gleich dicke Platten zu einem Stoss (Stapel) zusammengelegt. Wenn dabei eine Abschirmung notwendig ist, wird dann auf die untere Schicht eine metallische Abschirmauflage z. B. durch ein Vakuum-Aufdampfverfahren oder durch Galvanisierung aufgetragen. Auf die obere Schicht des Stapels (bei einer einseitigen Montage) werden durch Aufdampfung oder Galvanisierung Strompfäde aufgetragen, an die funktechnische Bauteile angelötet werden. Bei einer gewöhnlichen Montage werden in einem Stapel Durchgangslöcher hergestellt, in welche Anschlüsse für die funktechnischen Bauteile eingesetzt werden. Hierbei werden auf der oberen Folie (Platte) des Stapels kleine stromführende Ringe (Halbringe) gefertigt. Nach Einsatz eines funktechnischen Bauteiles, wie z. B. des Anschlusses eines Widerstandes, eines Kondensators od. dgl., wird der Anschluss des Elementes auf der Montageseite (im Unterteil des Stapels) gelötet. Ein Teil des Lotes, welches von dem Oberteil des Stapels her (von der Seite des Einsatzes des funktechnischen Bauteiles her) in den Ring (oder den Halbring) eindringt, bleibt dort nach seiner Erstarrung und verbindet damit zuverlässig ohne Klebstoff die Folien (Platten) miteinander. Die Montage ist somit zuverlässig und der dielektrische Verlustfaktor einer Leiterplatte ist extra niedrig, so dass sie in einem UHF-Bereich wie z. B. in Wandlern und Verstärkern von UHF-Parabolantennen, Satelliten- und terrestrischen Mobiltelefonen od. dgl. Anwendung finden können. Für den Fall, dass Strompfäde an beiden Seiten einer Leiterplatte (eine doppelseitige Montage) angeordnet werden sollen, werden dann keine Ringe hergestellt und die Montage erfolgt danach gleichzeitig auf der oberen und unteren Folie des Stapels.

In ähnlicher Weise werden biegsame Verbindungs(band)kabel und biegsame Induktivitätsspulen hergestellt. Bei der Herstellung der letzteren wird durch eine Senkung der dielektrischen Verluste zur Güte des Stromkreise beigetragen, so dass sich die Induktivitätsspulen z. B. als UHF-Resonanz-Band-Stromkreise verwenden lassen.

Man ist dabei auf keine irgendwelche zusätzliche Anlage für die Montage von funkelektronischen Geräten unter Anwendung von den vorgeschlagenen gedruckten Leiterplatten, Kabeln und Spulen angewiesen.

### Beispiel 3

Fig. 4 zeigt ein Beispiel für die Montage eines Widerstandes auf einer biegsamen mehrschichtigen Leiterplatte, die aus 4 Polyimid-Folien besteht, wobei
11 einen Widerstand, 12 Kupferringe auf der oberen Folie eines Stapels, 13 einen Anschluss des Widerstandes, 14 Durchgangslöcher der Leiterplatte, 15 eine untere leitende Schicht (Montageschicht), 16 Einzelfolien des Stapels und 17 Lottropfen bedeuten.

### Beispiel 4

Man wählt einen dünnen emailisolierten Silberdraht (-faser) mit einer Dicke von weniger als 80 µm aus. Danach wird dieser Draht in 10 gleich lange Werkstücke als Proben geschnitten. Die in dieser Weise geschnittenen Werkstücke werden nun zu einem Bündel zusammengefasst. Dann werden die Enden der Werkstücke angelötet. Ein einfachster, extra präziser Widerstand ist fertig !

### Literaturstellen

1. Resistory, kondensatory, transformatory, drosseli, kommutazionny ustroistwa REA (Widerstände, Kondensatoren, Transformatoren, Drosseln, Schaltmittel für funkelektronische Geräte); Nachschlagebuch, N.N. Akimow, Je.P. Waschtschukow, W.A. Prochorenko, Ju.P. Chodorjonok; Belarus, 1994, 591 Seiten.
2. Herstellung von Induktivitätsspulen bei Anwendung eines Flachkabels für gedruckte Leiterplatten. Edrington, Hincl. Laboratorien für angewandte Forschungen bei der Universität des Staates Texas.
3. Bogorodizky N.P., Passynkow W.W., Tarejew B.M. Elektrotechnitscheskie materialy (Elektrotechnische Werkstoffe), 7. Auflage, Leningrad, Verl. Energoatomisdat, Abteilung in Leningrad, 1985, 304 Seiten.
4. Ismerenija w elektronike (Messungen in der Elektronik); Nachschlagebuch, W.A. Kusnezow, W.A. Dolgow, W.M. Konewskich et al.; Herausgegeben von W.A. Kusnezow. Moskau, Verlag Energoatomisdat, 1987, 512 Seiten.
5. B. Zoj, E.M. Kartaschow, W.W. Schewelew. Sakonomernost ismenenija fisitscheskich charakteristik mnogoelementnych struktur polimerow i twjordych tel pri ismenenii tschisla elementow (Gesetzmässigkeit bei der Änderung der physikalischen Eigenschaften der Mehrelementstrukturen von Polymeren bei einer Änderung der Elementzahl). Moskau. Entdeckungsurkunde Nr. 207 vom 18.06.2002, Eintragungsnummer 245.
6. B. Zoj, E.M. Kartaschow, W.W. Schewelew. Sakonomernost raspredelenia snatschenij fisitscheskich charakteristik polimerow i twjordych tel pri wneschnem mnogofaktornom wosdejstwii (Gesetzmässigkeit bei der Verteilung der Werte von physikalischen Eigenschaften der Polymere bei einer äusseren Einflussnahme von mehreren Faktoren). Moskau. Entdeckungsurkunde Nr. 209 vom 02. Oktober 2002, Eintragungsnummer 248.
7. B. Zoj, E.M. Kartaschow, W.W. Schewelew. Jawlenije mnogoelementnogo masschtabnogo effekta charakteristik fisitscheskich objektjw (Erscheiungsform eines Mehrelement-Massstabeffektes, hervorgerufen durch die Eigenschaften eines physikalischen Objektes) (Zoj-Kartaschow-Schewelew-Effekt). Moskau. Entdeckungsurkunde Nr. 243 vom 16. Dezember 2003. Eintragungsnummer 287.
8. B. Zoj. Sakonomernost ismenenija fisitscheskich charakteristik odnoelementnych struktur polimerow i twjordych tel pri ismenenii masschtaba (Änderungsgesetzmässigkeit der physikalischen Eigenschaften der Einelementstrukturen von Polymeren und Festkörpern bei einer Massstabänderung) (B. Zoj-Effekt). Moskau. Entdeckungsurkunde Nr. 247 vom 02. März 2004. Eintragungsnummer 293.

## Patentansprüche

1. Werkstoff für die Bauteile von funkelektronischen Geräten mit einer mehrschichtigen oder Mehrelementenstruktur aus Schichten von dünnen Folien oder Fasern als Elementen in einer Menge von N > 1, wobei die Schichten oder Fasern als Elemente durch typengleiche Einzelfolien oder -fasern mit einer Dicke d von weniger als 80µm aus einem einzigen Material gebildet sind, die zu einem Stapel oder einem Bündel zusammengefasst sind, wobei sich bei einem Anstieg der Schichten im Stapel oder der Zahl der Fasern als Elemente im Bündel bei der angegebenen Dicke die physikalischen Eigenschaften des Werkstoffes proportionell dazu verstärken, während deren Dispersion abnimmt.

2. Werkstoff nach Anspruch 1, **dadurch gekennzeichnet, dass** als Folie Polyimid oder Quarz oder Glimmer oder Kupfer oder Silber oder Germanium oder Gallium verwendet wird.

3. Werkstoff nach Anspruch 1, **dadurch gekennzeichnet, dass** als Werkstoffe für die Fasern als Elemente Silber oder Kupfer oder Aluminium oder Nichrom oder Germanium oder Gallium verwendet wird.

4. Werkstoff nach Anspruch 2, **dadurch gekennzeichnet, dass** zum Erzeugen des Stapels einzelne Folien übereinandergelegt sind.

5. Werkstoff nach Anspruch 2, **dadurch gekennzeichnet, dass** eine einzelne Folie zu dem Stapel zusammengefaltet ist.

## Claims

1. Material for components of radio-electronic devices which has multi-layer or multi-element structure of thin films layers or elements-filaments in a quantity of N>1, said layers or elements-filaments are made of same-type separate films or filaments of thickness d less than 80 micrometers of the same material and united in a stack or a bunch, and when a quantity of layers in a stack or a quantity of elements-filaments in a bunch increases preserving the said thickness the physical properties of the material increase and the dispersion of the physical properties decrease.

2. Material as per claim 1, wherein polyimide or quartz or mica or copper or silver or germanium or gallium are used as films

3. Material as per claim 1, wherein silver or copper or aluminum or nichrome or germanium or gallium are used as materials for elements-filaments.

4. Material as per claim 2, wherein separate films are placed on another in order to form a stack.

5. Material as per claim 2, wherein a separate film is folded in to form a stack.

## Revendications

1. Matériau destiné aux constituants d'appareils radioélectroniques, ayant une structure de plusieurs couches ou de plusieurs éléments, constituée de couches formées de pellicules minces ou de fibres comme éléments dans une quantité de N > 1, les couches ou les fibres comme éléments étant constituées de pellicules ou fibres séparées du même type ayant une épaisseur « d » inférieure à 80 µm en matériau unique et qui sont rassemblées de manière à former une pile ou un faisceau, la multiplication des couches au sein de la pile ou des fibres comme éléments au sein du faisceau à l'épaisseur indiquée augmente de façon proportionelle à cela les caractéristiques physiques du matérieau, alors que leur dispersion baissent.

2. Matériau selon la revendication 1, **caractérisé par le fait qu'**en tant que pellicule est utilisé le polyimide ou le quartz ou le mica ou l'argent ou le germanium ou le gallium.

3. Matériau selon la revendication 1, cafactérisé par le fait qu'en tant de matériaux pour les fibres comme éléments est utilisé l'argent ou le cuivre ou l'aluminium ou le nichrome ou le germanium ou le gallium.

4. Matériau selon la revendication 2, **caractérisé par le fait que** pour former une pile les pellicules séparées sont posées l'une au-dessus de l'autre.

5. Matériau selon la revendication 2, **caractérisé par le fait qu'**une pellicule séparée est plissée en pile.
